# EUROPEAN PATENT APPLICATION

(11) **EP 2 192 621 A1**
(43) Date of publication of application: **02.06.2010**
(21) Application number: 08831737.5
(22) Date of filing: 01.09.2008
(51) Int. Cl.: H01L 31/042

(54) **SEALING MEMBER FOR SOLAR CELL PANEL AND SOLAR CELL MODULE**

(30) Priority: 18.09.2007 JP 2007240885
(71) Applicant: Nitto Denko Corporation, Ibaraki-shi, Osaka 567-8680 (JP); SHARP CORPORATION, Osaka-shi, Osaka 545-8522 (JP)
(72) Inventor: TARUNO, Tomohiro, Ibaraki-shi Osaka 567-8680 (JP); MUNAKATA, Yasunori, Toyohashi-shi Aichi 441-3106 (JP); ISHIKAWA, Masayuki, Ibaraki-shi Osaka 567-8680 (JP); NAITOH, Katsuyuki, Osaka-shi Osaka 545-8522 (JP)
(74) Representative: Schwabe - Sandmair - Marx
(86) International application number: PCT/JP2008/065662
(87) International publication number: WO 2009/037962

(57) **Abstract**

[Abstract] Disclosed is a sealing member for solar cell panels, which comprises an elastic layer, an insulating resin film arranged on the elastic layer, and a first water-stopping adhesive layer arranged on the insulating resin film.

## Description

### Technical Field

The present invention relates to a sealing member for solar cell panel and a solar cell module, and particularly to a sealing member for solar cell panel and a solar cell module in which it is used.

### Background Art

Conventionally, solar cell panels have been used mainly outdoors. In such usage, a solar cell panel is fixed to a frame fixing member or the like.
As the solar cell panel, there has been known a thin-film solar cell panel in which a power generation layer including a transparent electrode layer, a photoelectric conversion layer, and a metal electrode layer is interposed between a glass substrate and a resin layer. In this thin-film solar cell panel, the power generation layer is generally formed at a peripheral end portion. Accordingly, when water enters a space between the fixing member and the peripheral end portion of the solar cell panel, water enters the power generation layer, and the photoelectric conversion layer peels off the transparent electrode layer and the metal electrode layer, which causes the problem of a reduction in power generation efficiency. Therefore, it is necessary to waterproof the peripheral end portion of the thin-film solar cell panel.

For this purpose, it is proposed to, e.g., fix the peripheral end portion of the solar cell panel in a groove having a generally U-shaped cross-sectional shape of a frame member via a gasket (sealing member) to seal (waterproof) the peripheral end portion of the solar cell panel (see, e.g., Patent Document 1 shown below).
In addition, as a general-purpose sealing member, there is proposed, e.g., a foam of ethylene-propylene-type rubber (see, e.g., Patent Document 2 shown below).
Patent Document 1: Japanese Unexamined Patent No. 2005-277260
Patent Document 2: Japanese Unexamined Patent No. 2001-131320

In recent years, a thin-film solar cell panel used outdoors has been intended to be scaled up. Since a high voltage is placed on such a thin-film solar cell panel, excellent voltage resistance is required of a sealing member.
However, when only the foam of ethylene-propylene-type rubber is used as the sealing member, the voltage resistance is insufficient. In the thin-film solar cell panel using the sealing member, it may be impossible to prevent a problem such as damage due to the high voltage.

An object of the present invention is to provide a sealing member for solar cell panel having excellent water resistance and voltage resistance, and a solar cell module in which it is used.

### Means for Solving the Problems

To attain the object, a sealing member for solar cell panel of the present invention includes an elastic layer, an insulating resin film laminated on the elastic layer, and a first water-stopping self-adhesive layer laminated on the insulating resin film.
In the sealing member for solar cell panel of the present invention, it is preferable that the insulating resin film is made of polyethylene terephthalate.

In the sealing member for solar cell panel of the present invention, it is preferable that the first water-stopping self-adhesive layer is made of butyl rubber.
In the sealing member for solar cell panel of the present invention, it is preferable that the sealing member for solar cell panel of the present invention further includes a second water-stopping self-adhesive layer interposed between the elastic layer and the insulating resin film.
In the sealing member for solar cell panel of the present invention, it is preferable that the second water-stopping self-adhesive layer is made of butyl rubber.

In the sealing member for solar cell panel of the present invention, it is preferable that the elastic layer is made of ethylene-propylene-diene rubber.
In the sealing member for solar cell panel of the present invention, it is preferable that the elastic layer is formed of a foam.
In the sealing member for solar cell panel of the present invention, it is preferable that the elastic layer is formed of a foam of ethylene-propylene-diene rubber.

A solar cell module of the present invention includes a solar cell panel, the above-mentioned sealing member for solar cell panel which seals a peripheral end portion of the solar cell panel, and a fixing member engagedly holding the sealing member for solar cell panel.
In the solar cell module of the present invention, it is preferable that the sealing member for solar cell panel is disposed so as to come in contact with a side surface of the solar cell panel, a light-receiving surface thereof, and a back surface thereof opposite to the light-receiving surface at the peripheral end portion of the solar cell panel, and the sealing member for solar cell panel disposed on the back surface is formed longer than the sealing member for solar cell panel disposed on the light-receiving surface in a direction extending inwardly from the peripheral end portion of the solar cell panel.

### Effect of the Invention

The sealing member for solar cell panel of the preset invention includes the elastic layer, the insulating resin film, and the first water-stopping self-adhesive layer. Since the elastic layer functions as a shock absorbing layer, it is possible to ensure satisfactory fixation of the solar cell panel to the fixing member.
In addition, since the insulating resin film has excellent voltage resistance, it is possible to impart excellent voltage resistance to the solar cell module, and obtain the solar cell module having excellent durability.

Furthermore, since the first water-stopping self-adhesive layer has excellent water resistance, it is possible to impart excellent water resistance to the solar cell module, and prevent a reduction in power generation efficiency due to the entrance of water.
Since the power cell module of the present invention uses the sealing member for power cell panel described above, it is possible to ensure excellent voltage resistance and excellent water resistance.

### Brief Description of the Drawings

[FIG. 1] FIG. 1 shows an enlarged cross-sectional view of an embodiment of a sealing member for solar cell panel of the present invention.
[FIG. 2] FIG. 2 shows an enlarged cross-sectional view of another embodiment of the sealing member for solar cell panel of the present invention.
[FIG. 3] FIG. 3 shows an enlarged cross-sectional view of still another embodiment of the sealing member for solar cell panel of the present invention.
[FIG. 4] FIG. 4 shows a partially cross-sectional perspective view of a solar cell module using the sealing member for solar cell panel shown in FIG. 1.
[FIG. 5] FIG. 5 shows a process step view for illustrating the assembly of the solar cell module shown in FIG. 4,
   (a) showing the step of sticking the sealing member for solar cell panel to a peripheral end portion of the solar cell panel, and
   (b) showing the step of fixing the peripheral end portion of the solar cell panel.

### Embodiments of the Invention

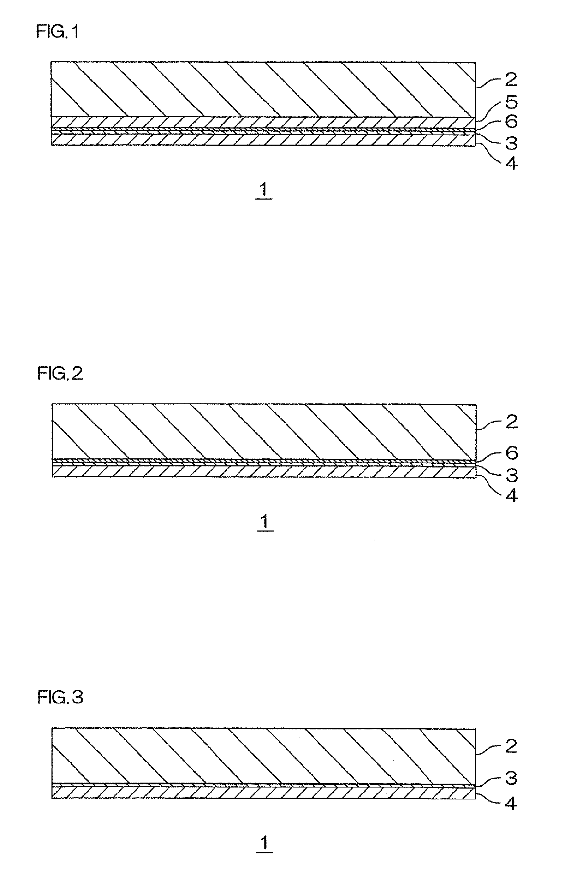

FIG. 1 shows an enlarged cross-sectional view of an embodiment of a sealing member for solar cell panel of the present invention.
Referring to FIG. 1, the sealing member for solar cell panel of the present invention (which may be hereinafter simply referred to also as "sealing member") is described hereinbelow.
In FIG. 1, the sealing member 1 is formed into a sheet-like or film-like shape, and includes an elastic layer 2, a second water-stopping self-adhesive layer 5 laminated on the elastic layer 2, a fibrous sheet 6 laminated on the second water-stopping self adhesive layer 5, an insulating resin film 3 laminated on the fibrous sheet 6, and a first water-stopping self-adhesive layer 4 laminated on the insulating resin film 3.

The elastic layer 2 is not particularly limited as long as it has a shock absorbing (cushioning) function. For example, the elastic layer 2 is formed of a molded piece of various rubber.
Examples of a material forming the elastic layer 2 that can be used include such as, e.g., ethylene-propylene-diene rubber (EPDM); a-olefin dicyclopentadiene such as, e.g., 1-butene;rubber-type copolymers containing, as a component, cyclic or non-cyclic polyene having a non-conjugated double bond such as, e.g., ethylidene norbornene; various rubbers such as e.g., ethylene-propylene rubber, ethylene-propylene terpolymer, silicone rubber, polyurethane-type rubber, polyamide-type rubber, natural rubber, polyisobutylene rubber, polyisoprene, chloroprene rubber, butyl rubber, nitrile-butyl rubber, styrene-butadiene rubber, styrene-butadiene-styrene rubber, styrene-isoprene-styrene rubber, styrene-ethylene-butadiene rubber, styrene-ethylene-butylene-styrene rubber, styrene-isoprene-propylene-styrene rubber, and acrylic rubber. Preferably, in terms of weathering resistance, EPDM can be used.

Examples of diene forming EPDM that can be used include cyclic dienes such as, e.g., 5-ethylidene-2-norbornene, 5-propylidene-5-norbornene, dicyclopentadiene, 5-vinyl-2-norbornene, 5-methylene-2-norbornene, 5-isopropylidene-2-norboronen, and norbornadiene,; chain non-conjugated dienes such as, e.g., 1,4-hexadiene, 4-methyl-1,4-hexaadiene, 5-methl-1,4-hexadiene, 5-methyl-1,5-heptadiene, 6-methyl-1,5-heptadiene, 6-methyl-1,7-octadiene, and 7-methyl-1,6-octadiene, and trienes such as, e.g., 2,3-diisopropylidene-5-norbornene, and 4-ethylidene-8-methyl-1,7-nonadiene.

Among such dienes, a diene that allows a reduction in diene content, and has a high vulcanization speed can be preferably used in terms of allowing the obtention of an EPDM foam having excellent heat resistance and weathering resistance. More specifically, 5-ethylidne-2-norbornen can be used.
The Mooney viscosity of EPDM is in a range of, e.g., 10 to 60 (ML1+4, 100 °C), or preferably 20 to 50 (ML1+4, 100 °C). When the Mooney viscosity is within the range shown above, an advantage is offered that a soft EPDM foam having excellent workability and softness can be obtained.

The diene content of EPDM expressed as an iodine value is in a range of, e.g., 0.5 to 50 (g/100 g), or preferably 10 to 30 (g/100 g). When the diene content is within the range shown above, excellent heat resistance and weathering resistance can be obtained. The ethylene content is in a range of, e.g., 50 to 75 wt%, or preferably 50 to 55 wt%. When the ethylene content is within the range shown above, an advantage is offered that permanent compression set at a low temperature is reduced.

EPDM can be used alone, or two or more different types thereof having different physical properties can be used in combination.
In the sealing member 1, the elastic layer 2 is preferably formed of a foam, or more preferably formed of an EPDM foam.
The foam can be obtained by heating a foaming composition containing any of the various rubbers described above, a foaming agent, a crosslinking agent, and an additive to cause foaming or crosslinkage thereof.

Examples of the foaming agent that can be used include thermolytic foaming agents such as an inorganic foaming agent and an organic foaming agent.
Examples of the inorganic foaming agent that can be used include ammonium carbonate, ammonium hydrogen carbonate, sodium hydrogen carbonate, ammonium nitrite, sodium borohydride, and azides.
Examples of the organic foaming agent that can be used include an N-nitroso-type compound (such as, e.g., N,N'-dinitrosopentamethylenetetramine or N,N'-dimethyl- N,N'-dinitrosoterephthalamide), an azo-type compound (such as, e.g., azobisisobutylonitrile, azodicarboxylic acid amide (ADCA), or barium azodicarboxylate), alkane fluoride (such as, e.g., trichloromonofluoromethane or dichloromonofluoromethane), a hydrazine-type compound (such as, e.g., paratoluenesulfonyl hydrazide, diphenylsulfone-3,3'-disulfonyl hydrazide, 4,4'-oxybis(benzenesulfonyl hydrazide) (OBSH), or allylbis(sulfonylhydrazide)), a semicarbazide-type compound (such as, e.g., p-toluylenesulfonylsemicarbazide or 4,4'-oxybis(benzenesulfonylsemicarbazide), and a triazole-type compound (such as, e.g., 5-morphoryl-1,2,3,4-thiatriazole).

Examples of the foaming agent that can be used also include a gas-filled microcapsule foaming agent. More specifically, there can be used a thermoexpansive particulate in which a thermoexpansive substance (such as, e.g., isobutane or pentane) is encapsulated in a microcapsule (microcapsule made of a thermoplastic resin such as, e.g., vinylidene chloride, acrylonitrile, acrylic acid ester, or methaclylic acid ester) or the like. As such a thermoexpansive particulate, a commercially available product such as, e.g., Microsphere (product name, commercially available from Matsumoto Yushi-Seiyaku Co., Ltd.).

Of such foaming agents, one can be used alone, or two or more can be used in combination. Among such foaming agents, ADCA can be preferably used.
The mixing ratio of the foaming agent based on 100 parts by weight of the rubber is in a range of, e.g., 0.1 to 100 parts by weight, or preferably 0.5 to 50 parts by weight.
The crosslinking agent is usually a vulcanizing agent. Examples of such a vulcanizing agent that can be used include sulfur, sulfur compounds, selenium, magnesium oxides, a lead monoxide, zinc oxides, organic peroxides, polyamines, oximes (such as, e.g., p-quinone dioxime or p,p'-dibenzoylquinone dioxime), nitroso compounds (such as, e.g., p-dinitrosobenzine), resins (such as, e.g., alkylphenol-formaldehyde resins or melamine-formaldehyde condensates), and ammonium salts (such as, e.g., ammoniumbenzoate).

Among such crosslinking agents, sulfur or sulfur compounds can be preferably used in terms of the vulcanization property of the foam, the physical property thereof such as durability due to a foaming property, and the like. More preferably, sulfur can be used.
Of such vulcanizing agents, one can be used alone, or two or more can be used in combination.
The mixing ratio of the vulcanizing agent can be determined appropriately in accordance with crosslinking (vulcanization) efficiency based on the type thereof. When the vulcanizing agent is sulfur or a sulfur compound, the mixing ratio thereof based on 100 parts by weight of the rubber is preferably in a range of, e.g., 0.1 to 10 parts by weight, or preferably 0.5 to 5 parts by weight.

Examples of the additive that can be used include a flame retardant, a vulcanization accelerator, a softener, a filler, and a foaming auxiliary.
The flame retardant is mixed when flame retardancy is required of the elastic layer 2. Examples of such a flame retardant that can be used include metal hydroxides of metal elements such as aluminum (Al), magnesium (Mg), calcium (Ca), nickel (Ni), cobalt (Co), tin (Sn), zinc (Zn), copper (Cu), iron (Fe), titanium (Ti), and boron (B). Among these metal hydroxides, aluminum hydroxide or magnesium hydroxide can be preferably used.

As the flame retardant, there can be also used, e.g., a complex metal hydroxide which is a metal hydroxide including two or more metal elements. Examples of such a complex metal hydroxide that can be used include sMgO·(1-s)NiO·cH2O (0<s<1, 0<c≤19), sMgO·(1-s)ZnO·cH2O (0<s<1, 0<c≤1), and sAl2O3·(1-s)Fe2O3·cH2O 0<s<1, 0<c≤3).

Among such complex metal hydroxides, a complex metal hydroxide including magnesium and nickel or zinc can be used. More specifically, a complex metal hydroxide represented by sMgO·(1-s)Q10·cH20 (where Q1 represents Ni or Zn, and 0<s<1 and 0<c≤1 are satisfied) can be used. More preferably, hydrates of magnesium oxide and nickel oxide, and hydrates of magnesium oxide and zinc oxide can be used.

The complex metal hydroxide may have a polygonal shape or a thin- plate shape. When the complex metal hydroxide having a polygonal shape is used, a highly foamed foam can be obtained.
The mean diameter of particles (mean particle diameter) of the metal hydroxide or the complex metal hydroxide is in a range of, e.g., about 0.5 to 10 µm, or preferably 0.6 to 6 µm. The mean particle diameter can be measured with, e.g., a laser-type particle size measuring device. When the mean particle diameter exceeds 10 µm, a highly foamed foam may not be easily obtained.

As the flame retardant, there can be also used a bromine-type compound. Examples of such a bromine-type compound that can be used include an imide-type bromine compound such as, e.g., ethylene-bis-tetra-bromophthalimide; a phthalic-acid-type bromine compound such as, e.g., tetrabromophthalic acid anhydride; a bisphenol-type bromine compound such as, e.g., tetrabromobisphenol A and tetrabromobisphenol S; a biphenyl-type bromine compound such as, e.g., hexabromobiphenyl ether, decabromodiphenyl oxide, octabromodiphenyl oxide, and tetrabromodiphenyl oxide; an aliphatic bromine compound such as, e.g., ethylene-bis-pentabromodiphenyl and 1,2-bis-tetrabromophenylethane; an alicyclic bromine compound such as, e.g., hexabromocyclododecane; an aromatic bromine compound such as, e.g., bis(tribromophenoxy)ethane, bis(pentabromophenyl)ethane, tetrabromobenzene, pentabromobenzene, hexabromobenzene, tris(2,3-dibromopropyl-1)isocyanurate, and brominated polyphenylene ether; a phenol-type bromine compound such as, e.g., tribromophenol; a styrene-type bromine compound such as, e.g., brominated polystyrene; an acrylic-type bromine compound such as, e.g., brominated polyacrylate; an epoxy-type bromine compound such as brominated-bisphenol-A-type epoxy resin or a modified product thereof, and a carboxylic-acid-type bromine compound.

Among such bromine-type compounds, bromine-type compounds other than decabromodiphenyl oxide are preferred.
When the flame retardant is a metal hydroxide or a complex metal hydroxide, the mixing ratio of the flame retardant based on 100 parts by weight of the rubber is in a range of, e.g., 30 to 200 parts by weight, preferably 40 to 180 parts by weight, or more preferably 50 to 150 parts by weight.

When the flame retardant is a bromine-type compound, the mixing ratio of the flame retardant with respect to the foaming composition is in a range of, e.g., 4 to 25 wt%, or preferably 10 to 15 wt%. When the mixing ratio of the bromine-type compound is under the range shown above, the flame retardant effect may be reduced and, when the flame retardant is used in combination with the complex metal hydroxide (complex metal hydroxide having a polygonal shape), the mixing ratio of the complex metal hydroxide may not be able to be reduced. On the other hand, when the mixing ratio of the bromine-type compound exceeds the range shown above, a highly foamed foam may not be able to be obtained.

The vulcanization accelerator is added to adjust a vulcanization property, or accelerate vulcanization. Examples of the vulcanization accelerator that can be used include guanidines, thiazoles, sulfene amides, thiurams, dithiocarbamic acids, xanthic acids, aldehyde ammonias, aldehyde amines, and thioureas.
The mixing ratio of the vulcanization accelerator based on 100 parts by weight of the rubber is in a range of, e.g., 0.1 to 10 parts by weight.

The softener is added to improve moldability or workability. Examples of the softener that can be used include e.g., paraffins, waxes, naphtenes, aromatic oils, asphalts, drying oils such as, flaxseed oils, animal/vegetable oils, petroleum-derived oils (such as, e.g., process oils), various low-molecular polymers (such as, e.g., low-molecular polyethylene glycol), phthalic acid esters, phosphoric acid esters, stearic acid or esters thereof, alkyl sulfonic acid esters, and tackifiers.

The mixing ratio of the softener is determined appropriately based on the physical properties of the elastic layer 2 or the like. For example, in terms of rubber physical properties, low toxicity, a low density property, miscibility, and the like, the mixing ratio of the softener based on 100 parts by weight of the rubber is in a range of, e.g., 10 to 100 parts by weight, preferably 15 to 80 parts by weight, or more preferably 20 to 60 parts by weight.
The filler is added to adjust the strength of the foam. Examples of the filler that can be used include carbon black. The filler is mixed at an appropriate ratio.

Examples of the foaming auxiliary that can be used include urea-type foaming auxiliaries. The foaming auxiliary is mixed at an appropriate ratio.
Of such additives, one can be used alone, or two or more can be used in combination.
To prepare the foaming composition, the individual components mentioned above are mixed at the foregoing mixing ratios, and uniformly mixed with each other. To mix the individual components mentioned above, the components mentioned above are kneaded with, e.g., a mixing roll, a pressure kneader, an extruder, or the like. Note that the components mentioned above are mixed at a temperature lower than a temperature at which the foaming agent causes foaming, and the foaming agent (vulcanizing agent) causes crosslinkage (vulcanization) (e.g., at a temperature in a range lower than 160 °C, or preferably 40 to 100 °C). The obtained foaming composition is molded into a sheet-like shape by a molding method such as, e.g., mixing roll, calendar roll, extrusion molding, press molding, or the like.

Then, the foaming composition mentioned above is heated at a temperature in a range of not more than 450 °C, or preferably 100 to 350 °C, whereby the foam is obtainable.
The foam thus obtained has a density (Weight of Foam (g)/Volume of Foam (g/cm³)) thereof in a range of, e.g., 0.01 to 0.5 g/cm³, and the expansion ratio (volume expansion ratio) thereof during the foaming is in a range of, e.g., 1.1 to 25 times or more, or preferably 1.5 to 20 times.

The thickness of the elastic layer 2 is in a range of, e.g., 0.5 to 30 mm, or preferably 1 to 10 mm.
The first water-stopping self-adhesive layer 4 is not particularly limited as long as it has a watertight function. Examples of a self-adhesive (first self-adhesive) forming the first water-stopping self-adhesive layer 4 that can be used include a rubber-type self-adhesive and a resin-type self-adhesive. Preferably, a rubber-type self-adhesive can be used.
In the rubber-type self-adhesive, an additive has been uniformly dispersed in rubber. Examples of the rubber that can be used include butyl rubber and rubber asphalt. In terms of durability and weathering resistance, butyl rubber can be preferably used. More preferably, reclaimed butyl rubber having excellent workability can be used.

In addition, synthetic rubber such as butadiene rubber, isoprene rubber, or polyisobutylene can also be used in combination.
Examples of the adder that can be used include a filler such as, e.g., calcium carbonate; a tackifier such as, e.g., a petroleum-derived resin, a phenol-type resin, a rosin-type resin, a terpene-type resin, or a hydrogenerated product thereof, and a softener such as, e.g., process oil or polybutene.

Of such additives, one can be used alone, or two or more can be used in combination. The mixing ratio of the additive based on 100 parts by weight of the rubber is such that the mixing ratio of the filler is in a range of, e.g., not more than 200 parts by weight, the mixing ratio of the tackifier is in a range of, e.g., 20 to 200 parts by weight, and the mixing ratio of the softener is in a range of, e.g., 5 to 150 parts by weight.
In the rubber-type self-adhesive, a crosslinking agent may also becontained in addition to the additives mentioned above.
The crosslinking agent is arbitrarily mixed in the rubber-type self-adhesive. There can be used a crosslinking agent which enables crosslinkage at a low temperature (of, e.g., not more than 180 °C), and causes crosslinkage at a relatively high speed. Examples of the cross-linking agent that can be used include a quinoide vulcanizing agent, a thiuram vulcanizing agent, a quinonedioxime vulcanizing agent, and a maleimide vulcanizing agent.

Examples of the quinoide vulcanizing agent that can be used include poly-p-dinitrosobenzene. Examples of the thiuram vulcanizing agent that can be used include tetramethylthiuramdisulfide, tetraethylthiuramdisulfide, tetrabutylthiuramdisulfide, tetrakis(2-ethylhexyl)thiuramdisulfide, dipentamethylenethiuramtetrasulfide, and tetramethylthiurammonosulfide. Examples of the quinonedioxime vulcanizing agent that can be used include p-quinondioxime and p,p'-dibenzoylquinonedioxime. Examples of the maleimide vulcanizing agent that can beused include N,N'-m-phenylenedimaleimide, N,N'-p-phenylenedimaleimide, and N,N'-ethylenedimaleimide.

Of such cross-linking agents, one can be used alone, or two or more can be used in combination.
The mixing ratio of the crosslinking agent based on 100 parts by weight of the rubber is in a range of, e.g., not more than 20 parts by weight, or preferably 0.5 to 20 parts by weight.
By mixing the crosslinking agent in the rubber-type self-adhesive, the rubber-type self-adhesive can be prepared as a rubber-type self-adhesive of a crosslinking type.

To form the first water-stopping self-adhesive layer 4, the first self-adhesive is prepared first.
To prepare the first self-adhesive, the individual components mentioned above are mixed at the foregoing mixing ratios, heated, and kneaded. For the kneading, there is used, e.g., a batch kneader such a pressure kneader, a Banbury mixer, or a mixing roll, a continuous kneader such as a double-shaft kneader, or the like. A heating temperature in the kneading is in a range of, e.g., 40 to 160 °C, or preferably 40 to 100 °C.

Then, the first self-adhesive is heated, and molded with a molding device such as, e.g., a calendar roll or an extruder, or preferably the calendar roll, whereby the first water-stopping self-adhesive layer 4 is obtainable.
The thickness (thickness of the paste) of the first water-stopping self-adhesive layer 4 thus obtained is in a range of, e.g., 10 to 1000 µm, or preferably 100 to 500 µm.

The fibrous sheet 6 is used to reinforce and support the insulating resin film 3 during the production. Examples of the fibrous sheet 6 that can be used include woven or non-woven fabric of cotton, spun rayon, synthetic fiber, or the like, and paper such as, e.g., Japanese paper or kraft paper. Preferably, woven fabric can be used.
The fibrous sheet 6 can be used alone, or two or more types thereof can be used in combination. The thickness of the fibrous sheet 6 is in a range of, e.g., 1 to 100 µm, or preferably 10 to 50 µm.

The insulating resin film 3 is not particularly limited as long as it is a film having an insulating function. Examples of an insulating resin forming the insulating resin film that can be used include synthetic resins such as polyethylene terephthalate (PET), polyimide, polyether nitrile, polyether sulfone, polyethylene naphthalate, and polyvinyl chloride. Preferably, PET can be used. Note that a woven or porous insulating resin film is not preferred because the insulating property thereof significantly deteriorates.

The thickness of the insulating resin film 3 is in a range of, e.g., not more than 100 µm, or preferably 1 to 80 µm.
The second water-stopping self-adhesive layer 5 is not particularly limited as long as it has a watertight function. For example, the second water-stopping self-adhesive layer 5 can be formed of a self-adhesive (second self-adhesive). Preferably, the second self-adhesive is formed of the same self-adhesive as the first self-adhesive. More preferably, the second self-adhesive is formed of butyl rubber. The second water-stopping self-adhesive layer 5 is formed by the same method as used to form the first water-stopping self-adhesive layer 4. The thickness of the second water-stopping self-adhesive layer 5 is the same as that of the first water-stopping self-adhesive layer 4.

Next, a description is given to a producing method of the sealing member 1.
First, in this method, the fibrous sheet 6 is laminated on the surface of the insulating resin film 3. To laminate the fibrous sheet 6, the fibrous sheet 6 is sticked to the surface of the insulating resin film 3 via a known adhesive. Note that, in the lamination of the fibrous sheet 6, the fibrous sheet 6 can also be laminated on the surface of the insulating resin film 3 by thermocompression. Next, the first water-stopping self-adhesive layer 4 is laminated on the back surface (surface opposite to the surface thereof on which the fibrous sheet 6 is laminated) of the insulating resin film 3. To laminate the first water-stopping self-adhesive layer 4, the first water-stopping self-adhesive layer 4 is molded into a sheet shape on the back surface of the insulating resin film 3 with the molding device mentioned above (preferably a calendar roll).

Next, the second water-stopping self-adhesive layer 5 is laminated on the surface of the fibrous sheet 6. To laminate the second water-stopping self-adhesive layer 5, the second water-stopping self-adhesive layer 5 is molded into a sheet shape with the molding device mentioned above (preferably a calendar roll) on the top surface of the fibrous sheet 6.
In this manner, the insulating resin film 3 can be obtained which has the first water-stopping self-adhesive layer 4 laminated on the back surface thereof, and has the fibrous sheet 6 and the second water-stopping self-adhesive layer 5 successively laminated on the top surface thereof.

Next, in this method, the elastic layer 2 separately prepared is thermocompressed onto the insulating resin film 3 so as to come in contact with the second water-stopping self-adhesive layer 5. At this time, since the fibrous sheet 6 is laminated on the insulating resin film 3, the insulating resin film 3 can be prevented from being deformed by heat.
In this manner, the sealing member 1 can be obtained which includes the elastic layer 2, and the second water-stopping self-adhesive layer 5, the fibrous sheet 6, the insulating resin film 3, and the first water-stopping self-adhesive layer 4 successively laminated on the elastic layer 2.

In the description given above, in the production of the sealing member 1, the fibrous sheet 6 is laminated first on the surface of the insulating resin film 3. Then, the first water-stopping self-adhesive layer 4 is laminated on the back surface of the insulating resin film 3 and, thereafter, the second water-stopping self-adhesive layer 5 is laminated on the fibrous sheet 6. However, the order of the lamination thereof is not particularly limited. For example, it is also possible to, e.g., first successively laminate the fibrous sheet 6 and the second water-stopping self-adhesive layer 5 on the surface of the insulating resin film 3, and then laminate the first water-stopping self-adhesive layer 4 on the back surface of the insulating resin film 3.

In the description given above, the second water-stopping self-adhesive layer 5 is formed on the surface of the fibrous sheet 6. However, for example, it is also possible not to form the second water-stopping self-adhesive layer 5, as shown in FIG. 2. If the second water-stopping self-adhesive layer 5 is provided, it is possible to ensure excellent adhesion between the elastic layer 2 and the insulating resin film 3. It is also possible to prevent the insulating resin film (e.g., PET) 3 from decomposed (e.g., hydrolyzed) by water at a high humidity.

In addition, in the description given above, the fibrous sheet 6 is formed on the surface of the insulating resin film 3. However, for example, it is also possible not to form the fibrous sheet 6, as shown in FIG. 3.

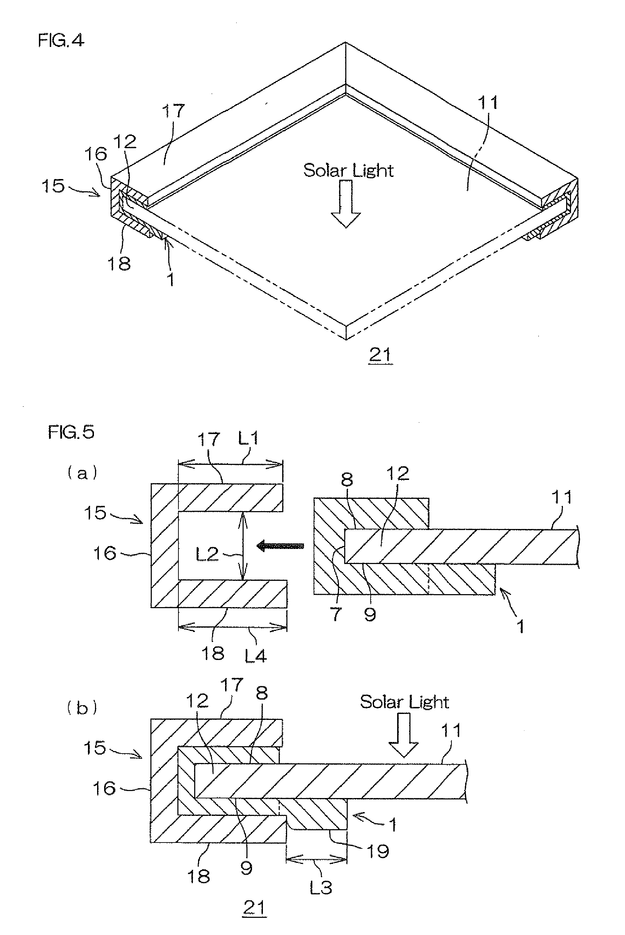

FIG. 4 shows a partially cross-sectional perspective view of a solar cell module using the sealing member for solar cell panel shown in FIG. 1. FIG. 5 shows a process step view for illustrating the assembly of the solar cell module shown in FIG. 4, (a) showing the step of sticking the sealing member for solar cell panel to a peripheral end portion of the solar cell panel, and (b) showing the step of fixing the peripheral end portion of the solar cell panel.

Next, a description is given to the solar cell module using the sealing member 1 described above with reference to FIGS. 4 and 5.
In FIG. 4, the solar cell module 21 includes a solar cell panel 11, the sealing member 1, and a frame 15 as a fixing member.
The solar cell panel 11 has a generally rectangular flat-plate shape, and a known solar cell panel such as a thin-film type is used. As shown in FIG. 5, the thin-film-type solar cell panel 11 comprises a power generation layer, a glass substrate (not shown) formed on a light receiving surface 8 which receives solar light of the power generation layer, a resin layer (not shown), and a protective layer (not shown) which are successively formed on a back surface (surface opposite to the light receiving surface) 9 of the power generation layer. On the back surface 9 of the solar cell panel 11, there are provided a terminal cable (not shown) for extracting electricity from the power generation layer, and a terminal box (not shown) for containing the terminal cable, though not shown.

The thickness of the solar cell panel 11 is in a range of, e.g., 2 to 10 mm, or preferably 4 to 6 nm.
The sealing member 1 is formed in a sheet or film shape extending in a longitudinal direction to seal a peripheral end portion 12 of the solar cell panel 11.
More specifically, as shown in FIG. 5(a), the sealing member 1 is formed in a generally U-shaped cross-sectional shape in contact relation with a side surface 7, the light receiving surface 8, and the back surface 9 at the peripheral end portion 12 of each of the sides of the solar cell panel 11. The sealing member 1 is sticked to the peripheral end portion 12 of the solar cell panel 11 so as to bring the first water-stopping self-adhesive layer 4 thereof into contact with each of the surfaces of the peripheral end portion 12.

The sealing member 1 disposed on the back surface 9 is formed longer than the sealing member 1 disposed on the light receiving surface 8 in a direction extending inwardly from the peripheral end portion 12 of the solar cell panel 11. More specifically, the sealing member 1 disposed on the back surface 9 is formed longer than the sealing member 1 disposed on the light receiving surface 8 by, e.g., 1 to 30 mm, or preferably 10 to 20 mm.
As shown in FIGS. 4 and 5, the frame 15 is provided along each of the sides of the solar cell panel 11. The frame 15 is formed in a generally U-shaped cross-sectional shape which inwardly opens, and integrally includes a side-surface sidewall 16 having a flat-plate shape, a light-receiving-surface sidewall 17 having a flat-plate shape, and extending inwardly from an upper portion of the side-surface sidewall 16, and a back-surface sidewall 18 having a flat-plate shape, and extending inwardly from a lower portion of the side-surface sidewall 16. The frame 15 is formed of, e.g., a metal material (such as aluminum) or a resin material, or preferably formed of aluminum. The frame 15 has longitudinal end portions along the individual sides thereof which are joined to each other to form four corners, and assembled in a frame shape when viewed in plan view.

The dimensions of the frame 15 are set appropriately based on the dimensions of the solar cell panel 11 and the sealing member 1. The length L1 of the inner surface of the light-receiving-surface sidewall 17 is in a range of, e.g., 5 to 30 mm, or preferably 10 to 20 mm. The length L4 of the inner surface of the back-surface sidewall 18 is in a range of, e.g., 5 to 50 mm, or preferably 15 to 25 mm. The length L2 of the inner surface of the side-surface sidewall 16 is in a range of, e.g., 5 to 15 mm, or preferably 8 to 10 mm. The respective thicknesses of the peripheral-surface sidewall 16, the light-receiving-surface sidewall 17, and the back-surface sidewall 18 are in a range of, e.g., 1 to 5 mm, or preferably 2 to 4 mm.

The frame 15 further engagedly holds the sealing member 1 engagedly holding the peripheral end portion 12 of the solar cell panel 11. Specifically, the light-receiving-surface sidewall 17 covers the sealing member 1 disposed on the light receiving surface 8, the side-surface sidewall 16 covers the sealing member 1 disposed on the side surface 7, and the back-surface sidewall 18 covers the sealing member 1 disposed on the back surface 9.
The inner end portion of the sealing member 1 disposed on the back surface 9 is exposed from the back-surface sidewall 18 of the frame 15. The length L3 of the exposed portion 19 is in a range of, e.g., 1 to 30 mm, or preferably 10 to 20 mm.

The inner end portion of the sealing member 1 disposed on the light receiving surface 8 is disposed not flush with, but rather slightly closer to the peripheral-end side than the inner end portion of the light-receiving-surface sidewall 17 of the frame 15 in the inward direction. For example, the inner end portion of the sealing member 1 disposed on the light receiving surface 8 is disposed closer to the peripheral-end side by, e.g., 1 to 3 mm.
Next, a description is given to an assembly method of the solar cell module 21.
First, in this method, the solar cell module 11 is sealed with the sealing member 1, as shown in FIG. 5(a). To seal the solar cell module 11 with the sealing member 1, the first water-stopping self-adhesive layer 4 of the sealing member 1 is brought into contact with each of the surfaces of the peripheral end portion 12 so as to achieve the layout described above.

Next, in this method, the peripheral end portion 12 of the solar cell module 11 sealed with the sealing member 1 is press-fitted into the frame 15, as indicated by the arrow of FIG. 5(a), and shown in FIG. 5(b). More specifically, the peripheral end portion 12 of the solar cell panel 11 is inserted into the frame 15 so as to be engagedly held by the frame 15 via the sealing member 1.
Accordingly, the sealing member 1 is engagedly held by the frame 15, and the peripheral portion 12 of the solar cell module 11 is fixed in the frame 15 via the sealing member 1.

By causing the frame 15 to engagedly hold the sealing member 1, the sealing member 1 is compressed to a volume at a ratio in a range of 10 to 90 vol%, or preferably 20 to 80 vol% with respect to the volume before the sealing member 1 is engagedly held.
As a result, the solar cell panel 11 is sealed with the sealing member 1, and the sealing member 1 is engagedly held by the frame 15 to allow the assembly of the solar cell module 21 fixed by the frame 15.

In the sealing member 1, the elastic layer 2 functions as a shock absorbing layer. Therefore, it is possible to ensure excellent fixation of the solar cell panel 11 to the frame 15.
Since the insulating resin film 3 has excellent voltage resistance, it is possible to impart excellent voltage resistance to the solar cell module 21, and obtain the solar cell module 21 having excellent durability.
Moreover, since the first water-stopping self-adhesive layer 4 has excellent water resistance, it is possible to impart excellent water resistance to the solar cell module 21, and prevent a reduction in power generation efficiency due to the entrance of water.

In addition, since the solar cell module 21 uses the sealing member 1, it is possible to ensure excellent voltage resistance and excellent water resistance.
In the description given above, the sealing member 1 disposed on the back surface 9 is formed longer than the sealing member 1 disposed on the light-receiving surface 8 in the direction inwardly extending from the peripheral end portion 12 of the solar cell panel 11. However, it is also possible to, e.g., form the sealing member 1 disposed on the back surface 9 as long as (see the broken line of FIG. 5) or shorter than the sealing member 1 disposed on the light receiving surface 8.

Preferably, the sealing member 1 disposed on the back surface 9 is formed longer than the sealing member 1 disposed on the light receiving surface 8 in the direction inwardly extending from the peripheral end portion 12 of the solar cell panel 11. This more positively ensures insulation between the frame 15 and the solar cell panel 11, and can prevent discharge between the frame 15 and the solar cell panel 11 even at the time of unexpected momentary occurrence of a voltage, such as a lightning surge.

### EXAMPLES

Hereinbelow, the present invention is described more specifically by showing the examples and the comparative example. However, the present invention is by no means limited thereto.

### EXAMPLE 1

### (Production of Sealing Member for Solar Cell Panel)

100 parts of EPDM (EPT4021 commercially available from Mitsui Chemical, Inc.) having a Mooney viscosity of 23 (ML1+4, 100 °C), 20 parts of ADCA, 5 parts of an urea-type foaming auxiliary, 100 parts of ethylene-bis-pentabromodiphenyl, 50 parts of aluminum hydroxide, 50 parts of magnesium hydroxide, 10 parts of carbon black, 1.5 parts of sulfur, 5 parts of zinc oxide, 1.2 parts of dithiocarbamic acid salts (vulcanization accelerator), 1.0 part of thiazoles (vulcanization accelerator), 3 parts of stearic acid powder, 35 parts of a process oil, and 1 part of low molecular polyethylene glycol were kneaded with a pressure kneader to prepare a foaming composition. By molding the foaming composition into a sheet shape with an extruder, an unvulcanized sheet having a thickness of 10 mm was obtained, and then heated in an oven at 160 °C for 20 minutes to be vulcanized and foamed. In this manner, an elastic layer made of an EPDM foam was produced.

Meantime, 1000 g of reclaimed butyl rubber having a Mooney viscosity of 44±6 (ML1+4, 100 °C) was loaded in a 5 L pressure kneader heated to 120 °C, and 1500 g of calcium carbonate powder was loaded therein, and kneaded for about 5 minutes. Into the 5 L pressure kneader, 500 g of a tackifier (petroleum-derived resin "Escorez 1202" commercially available from Exxon Mobil Corporation) was loaded and kneaded for about 10 minutes, and 100 g of a softener A ("Polybutene HV300" commercially available from Nippon Petrochemicals Co., Ltd.) and 300 g of a softener B ("Process Oil PW90" having a weight average molecular weight of 500, and commercially available from Idemitsu Kosan Co., Ltd.) were further kneaded in several separate steps for about 10 minutes. Thereafter, a kneaded material was collected from the kneader to prepare a rubber-type self-adhesive.

Then, an insulating resin film made of PET, and having a thickness of 25 µm was prepared, and a fibrous sheet made of woven fabric was sticked to the surface of the insulating resin film via an adhesive. Thereafter, the insulating resin film with the fibrous sheet was set on a calendar roll, and a first water-stopping self-adhesive layer made of the rubber-type self-adhesive was laminated on the back surface of the insulating resin film. Subsequently, on the surface of the fibrous sheet, a second water-stopping self-adhesive layer made of the same rubber-type self-adhesive as described above was laminated (see FIG. 1).

In this manner, a sealing member for solar cell panel having a thickness of 3.0 mm was produced in which the second water-stopping self-adhesive layer, the fibrous sheet, the insulating resin film, and the first water-stopping self-adhesive layer were successively laminated on the elastic layer.

### (Production of Solar Cell Module)

The sealing member for solar cell panel produced as described above was sticked to the peripheral end portion of a solar cell panel (thin-film solar cell panel having a thickness of 5 mm) such that the first water-stopping self-adhesive layer in a generally U-shaped shape came in contact with the peripheral end portion of the solar cell panel (see FIG. 5(a)).

Then, a frame made of aluminum, having a U-shaped cross-sectional shape, and including a back-surface sidewall, a peripheral-surface sidewall, and a light-receiving-surface sidewall was prepared. In the frame, the length of the inner surface of the light-receiving-surface sidewall was 10 mm, the length of the inner surface of the back-surface sidewall was 11 mm, and the length of the inner surface of the side-surface sidewall was 7 mm. The thickness of each of the walls was 2.0 mm.
Then, the peripheral end portion of the solar cell panel was fixed. That is, the peripheral end portion of the solar cell panel was inserted into the frame such that the sealing member was engagedly held by the frame.

The engagedly held sealing member was compressed to a volume at a ratio of 33 vol% with respect the volume before the sealing member was engagedly held. That is, the thickness of the sealing member was reduced from 3.0 mm to 1.0 mm. Note that the sealing member sticked to the back surface was formed longer by about 2.5 mm than the sealing member sticked to the light receiving surface.
The inner end portion of the sealing member on the back surface was exposed from the inner end portion of the back-surface sidewall of the frame, and the length of the exposed portion was about 10 mm.

Further, the inner end portion of the sealing member on the light receiving surface was covered with the light-receiving-surface sidewall of the frame. Specifically, the inner end portion of the sealing member sticked to the light receiving surface was disposed closer by about 1.5 mm to the peripheral-end side than the inner end portion of the light-receiving-surface sidewall of the frame in the inward direction.

### EXAMPLE 2

A sealing member for solar cell panel was produced in the same manner as in EXAMPLE 1 except that, in the production of the sealing member for solar cell panel, the thickness of the insulating resin film was changed from 25 µm to 18 µm. Subsequently, a solar cell module was produced.

### EXAMPLE 3

A sealing member for solar cell panel was produced in the same manner as in EXAMPLE 1 except that, in the production of the sealing member for solar cell panel, the thickness of the insulating resin film was changed from 25 µm to 50 µm. Subsequently, a solar cell module was produced.

### EXAMPLE 4

A solar cell module was produced in the same manner as in EXAMPLE 1 except that the length of the sealing member for solar cell panel sticked to the back surface of the solar cell panel was adjusted to be the same as the length of the sealing member for solar cell panel sticked to the light receiving surface of the solar cell panel (see the broken line of FIG. 5(b)).

More specifically, the inner end portion of the sealing member sticked to the light receiving surface was disposed closer by about 1.5 mm to the peripheral-end side than the inner end portion of the light-receiving-surface sidewall of the frame in the inward direction.
In addition, the inner end portion of the sealing member sticked to the back surface was disposed closer by about 2.5 mm to the peripheral-end side than the inner end portion of the back-surface sidewall of the frame in the inward direction.

### COMPARATIVE EXAMPLE 1

A sealing member for solar cell panel was produced in the same manner as in EXAMPLE 1 except that, in the production of the sealing member for solar cell panel, spun rayon fabric having a thickness of 0.2 mm was used instead of the insulating resin film. Subsequently, a solar cell module was produced.

### (Evaluation)

### (1) Voltage Resistance Test (Impulse Voltage Test)

In each of the solar cell modules obtained in the examples and the comparative example, an impulse voltage of 8 kV (under the conditions of application class A, and a maximum system voltage of 1000 V according to the IEC standard 61730) was applied between the frame and the solar cell panel under room temperature conditions (at a temperature of 25 °C and a relative humidity of 25%).

As a result, in EXAMPLES 1 to 4, discharge or marks thereof were not recognized.
By contrast, in COMPARATIVE EXAMPLE 1, both discharge and marks thereof were recognized.

### (2) Water Stopping Test A

Each of the solar cell modules obtained in EXAMPLES 1 to 4 and COMPARATIVE EXAMPLE 1 was allowed to stand under high-temperature and high-humidity conditions (at a temperature of 85 °C and a relative humidity of 85%) for 2000 hours. As a result, in EXAMPLES 1 to 4 and COMPARATIVE EXAMPLE 1, there was no significant difference between variations in appearance and electric characteristics from the initial period. Therefore, it could be recognized that there was no degradation due to the entrance of water, and water-stopping properties were excellent.

### (3) Water Stopping Test B

Each of the solar cell modules obtained in EXAMPLES 1 to 4 and COMPARATIVE EXAMPLE 1 was placed perpendicularly to a wall surface, and the surface of the solar cell module was sprinkled with water (4 L/minute) so that the water-stopping test was evaluated.

As a result, in each of EXAMPLES 1 to 4 and COMPARATIVE EXAMPLE 1, the entrance of water was not recognized at the peripheral end portion of the solar cell panel.
While the illustrative embodiments of the present invention are provided in the above description, such is for illustrative purpose only and it is not to be construed limitative. Modification and variation of the present invention which will be obvious to those skilled in the art in the technical field concerned is to be covered by the following claims.

### Industrial Applicability

The sealing member for solar cell panel of the present invention can be used for the waterproofing of a solar cell module or the like.

## Claims

1. A sealing member for solar cell panel comprising:
an elastic layer;
an insulating resin film laminated on the elastic layer; and
a first water-stopping self-adhesive layer laminated on the insulating resin film.

2. The sealing member for solar cell panel according to Claim 1, wherein the insulating resin film is made of polyethylene terephthalate.

3. The sealing member for solar cell panel according to Claim 1, wherein the first water-stopping self-adhesive layer is made of butyl rubber.

4. The sealing member for solar cell panel according to Claim 1, further comprising:
a second water-stopping self-adhesive layer interposed between the elastic layer and the insulating resin film.

5. The sealing member for solar cell panel according to Claim 4, wherein the second water-stopping self-adhesive layer is made of butyl rubber.

6. The sealing member for solar cell panel according to Claim 1, wherein the elastic layer is made of ethylene-propylene-diene rubber.

7. The sealing member for solar cell panel according to Claim 1, wherein the elastic layer is formed of a foam.

8. The sealing member for solar cell panel according to Claim 7, wherein the elastic layer is formed of a foam of ethylene-propylene-diene rubber.

9. A solar cell module comprising:
a solar cell panel;
the sealing member for solar cell panel according to any one of Claims 1 to 8, which seals a peripheral end portion of the solar cell panel; and
a fixing member engagedly holding the sealing member for solar cell panel.

10. The solar cell module according to Claim 9, wherein
the sealing member for solar cell panel is disposed so as to come in contact with a side surface of the solar cell panel, a light-receiving surface thereof, and a back surface thereof opposite to the light-receiving surface at the peripheral end portion of the solar cell panel, and
the sealing member for solar cell panel disposed on the back surface is formed longer than the sealing member for solar cell panel disposed on the light-receiving surface in a direction extending inwardly from the peripheral end portion of the solar cell panel.
